# EUROPEAN PATENT SPECIFICATION

(11) **EP 3 439 177 B1**
(45) Date of publication and mention of the grant of the patent: **22.09.2021**
(21) Application number: 17184438.4
(22) Date of filing: 02.08.2017
(51) Int. Cl.: H03G 1/00, H03F 3/45

(54) **GAIN CONTROL CIRCUIT FOR A VARIABLE GAIN AMPLIFIER**
VERSTÄRKUNGSREGLUNGSSCHALTUNG FÜR EINEN VERSTÄRKER MIT VARIABLER VERSTÄRKUNG
CIRCUIT DE COMMANDE DE GAIN POUR AMPLIFICATEUR À GAIN VARIABLE

(43) Date of publication of application: 06.02.2019
(73) Proprietor: IHP GmbH - Innovations for High Performance Microelectronics / Leibniz-Institut für innovative Mikroelektronik, 15236 Frankfurt (Oder) (DE)
(72) Inventor: Awny, Ahmed, 30853 Langenhagen (DE); Kissinger, Dietmar, 91054 Buckenhof (DE)
(74) Representative: Eisenführ Speiser

(56) References cited:
- US-A1- 2002 196 080
- US-A1- 2003 169 114
- US-B1- 6 809 591

## Description

### FIELD OF THE INVENTION

The invention relates to gain control circuit for a variable gain amplifier (VGA), which comprises a first transistor stack to which at least one input signal that is to be amplified by the VGA is to be applied and a second transistor stack to which differential gain control voltages for controlling the gain of the VGA are to be applied. The invention further relates to an amplification circuit comprising a VGA and the gain control circuit as well as to a corresponding gain control method.

### BACKGROUND OF THE INVENTION

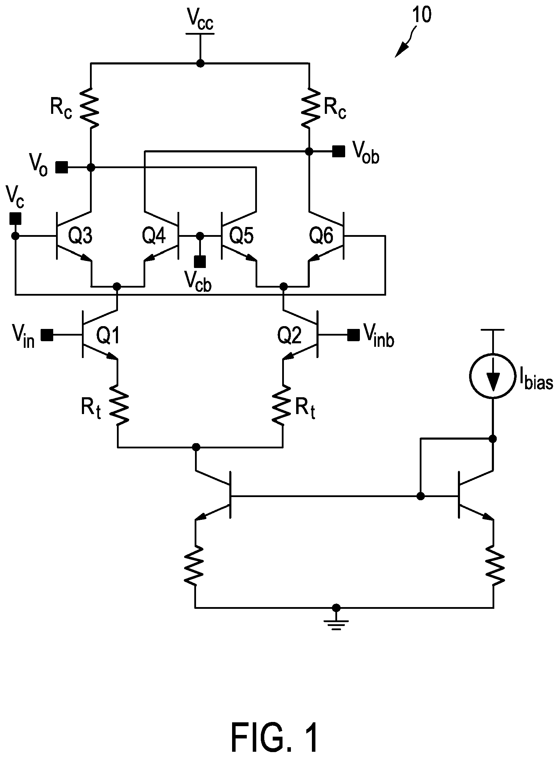

VGAs are important building blocks in systems where amplification and processing of analog signals with low distortion over a high input dynamic range is required. Fig. 1 shows schematically and exemplarily a VGA 10 as it is known in the art that is realized by making use of a Gilbert-cell. This type of VGA is often used in broadband applications, where the RF input signals Vᵢₙ and V_{inb} are applied to a lower stack formed by a pair of bipolar transistors Q1 and Q2 and an upper stack formed by two parallel pairs of bipolar transistors Q3 and Q4 respectively Q5 and Q6 is used for gain control by means of changing the potential V_{c}-V_{cb} of the differential gain control voltages V_{c} and V_{cb}. In Gilbert-cell based VGAs, however, two collectors (here the collectors of Q3 and Q5 respectively of Q4 and Q6) are attached to each output node Vₒ and V_{ob}, which increases the capacitive loading at these two nodes, increasing the time constant and hence reducing the bandwidth.

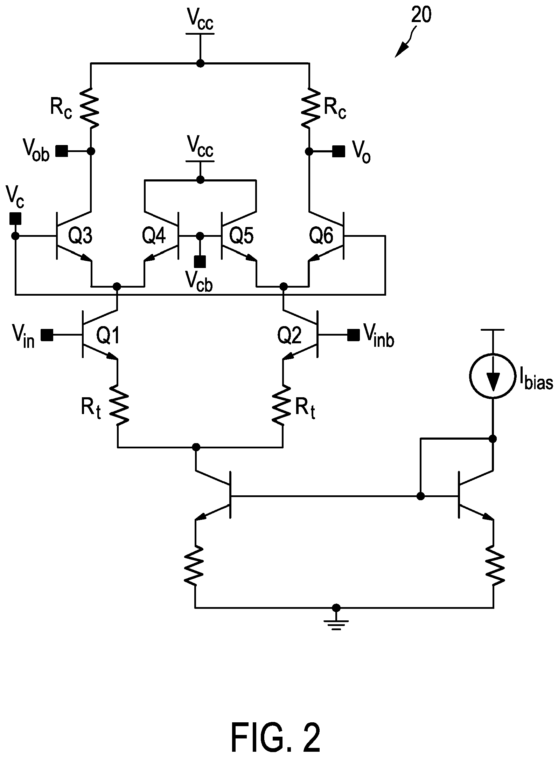

Another topology for the realization of VGAs that is known in the art is the current-steering topology, which is described, for instance, in I. Sarkas et al., "An 18-Gb/s, Direct QPSK Modulation SiGe BiCMOS Transceiver for Last Mile Links in the 70-80GHz Band," IEEE Journal of Solid-State Circuits, Vol. 45, No. 10, pages 1968 to 1980, October 2010 and in W.M.C. Sansen and R.G. Meyer, "Distortion in bipolar transistor variable-gain amplifiers," IEEE Journal of Solid-State Circuits, Vol. 8, No. 8, pages 275 to 282, August 1973, the contents of which are incorporated herein in their entirety. A VGA 20 that is realized by making use of the current-steering topology is schematically and exemplarily shown in Fig. 2. Here, the RF input signals Vᵢₙ and V_{inb} are also applied to the lower stack of transistors Q1 and Q2 and the upper stack of transistors Q3 to Q6 is used for gain control as follows: when V_{c} is higher than V_{cb} by about 3·V_{T}, where V_{T} is the thermal voltage k·T/q (k being the Boltzmann constant, T the temperature and q the magnitude of the electrical charge of the electron) of the bipolar transistor, which is 26 mV at room temperature, then the AC current generated at the collectors of Q1 and Q2 is steered to the transistors Q3 and Q6 and the gain is maximal. On the other hand, when V_{cb} is higher than V_{c}, then the AC current from the collectors of Q1 and Q2 is steered to the transistors Q4 and Q5 instead of Q3 and Q6 and the gain is minimal.

As normally the input RF signals Vᵢₙ and V_{inb} have a constant common-mode, the available head-room (limited by the supply voltage V_{cc} and the common mode of the RF input signals Vᵢₙ and V_{inb}) to make sure that all transistors in the high frequency path Q1 to Q6 work in the active region, is divided among the lower stack of transistors Q1 and Q2 and the upper stack of transistors Q3 to Q6. The head-room indicates how much collector- base voltage is available for a certain transistor before it goes into saturation. For a normal operation of a transistor, the base-collector junction has to stay in the reverse-biased region, i.e., the collector-base voltage has to be greater than zero (V_{cb} must be > 0). In this respect, it has been realized by the inventors that if the RF input signals Vᵢₙ and V_{inb} are small in amplitude and the maximum gain is desired, then the upper-stack transistors Q3 to Q6 need more head-room than the lower stack transistors Q1 and Q2, since the voltages V_{cb,Q3-Q6} in the upper stack move with a higher amplitude in comparison to the voltages V_{cb,Q1,Q2} in the lower stack. On the other hand, if the input RF signals Vᵢₙ and V_{inb} are large in amplitude and less than a unity gain (attenuation) is required from the VGA, then more head-room is necessary to be allocated to the lower stack transistors Q1 and Q2 than to the upper stack transistors Q3 to Q6, since V_{cb,Q1,Q2} moves with a higher amplitude in comparison to V_{cb,Q3-Q6}.

US 2002/0196080 A1 discloses a gain control circuit which has a first differential input circuit comprising: a differential pair of transistors Tr1 and Tr3 in which transistors Tr2 and Tr4 connected to diodes are inserted; a second differential input circuit comprising a pair of the transistor Tr3 and a transistor Tr5; and a current source circuit comprising a transistor Tr6 and an emitter resistor R3, and to which first to third individual control input signals VCLS1 to VCLS3 each having a predetermined inclination and an offset value, obtained by shifting the level of a control input signal VCNT are supplied, gain control signals VAGC having a linear characteristic, a monotone increase characteristic of which curve opens upwards, and a monotone increase characteristic of which curve opens sharply upwards are supplied in accordance with a monotone increase region of which curve opens upwards, a linear region, and a monotone increase region of which curve opens downwards, respectively, of a differential pair of transistors TrlI and Trl2 and a differential pair of transistors Trl3 and Trl4 at the second stage of a differential amplification circuit.

### SUMMARY OF THE INVENTION

It is an object of the invention to provide a gain control circuit for a VGA, which comprises a first transistor stack to which at least one input signal that is to be amplified by the VGA is to be applied and a second transistor stack to which differential gain control voltages are to be applied, which can better make sure that the transistors of a VGA work in the active region. It is a further object of the invention to provide an amplification circuit comprising a VGA and the gain control circuit as well as to provide a corresponding gain control method. According to an aspect of the invention, a gain control circuit for a variable gain amplifier, VGA, which comprises a first transistor stack to which at least one input signal that is to be amplified by the VGA is to be applied and a second transistor stack to which differential gain control voltages for controlling the gain of the VGA are to be applied, is provided, comprising:
- a gain-control differential pair circuit, which comprises two branches, a first one of the two branches comprising a first one of two transistors and the other one of the two branches comprising the other one of the two transistors, the two transistors forming a differential pair, for generating the differential gain control voltages in dependence of a gain control signal applied to the first one of the two transistors,
   wherein a fixed reference signal is applied to the other one of the two transistors, wherein the gain-control differential pair circuit further comprises two load resistances for converting the gain control signal and the fixed reference signal into the differential gain control voltages, wherein further a source degeneration resistor for increasing the range in which the gain control signal can change the gain of the gain-control differential pair circuit is provided between the two branches of the gain-control differential pair circuit, and
- a common-mode adjustment circuit for adjusting the common mode of the differential gain control voltages in dependence of a desired amplification of the VGA,
wherein the common-mode adjustment circuit comprises a double current mirror circuit comprising two further transistors, each of which is connected to a different branch of the two branches of the gain-control differential pair circuit, for equally providing a bias current to each of the two branches of the gain-control differential pair circuit, and
wherein the common-mode adjustment circuit comprises a current source for providing a current and a control circuit for providing the current to generate a part of the bias current in dependence of a desired amplification of the VGA.

Since the gain control circuit comprises the common-mode adjustment circuit, which adjusts the common mode of the differential gain control voltages in dependence of a desired amplification of the VGA, it can be possible to divide the available head-room among the first transistor stack and the second transistor stack, e.g., the lower stack of transistors Q1 and Q2 and the upper stack of transistors Q3 to Q6 shown in Figs. 1 and 2, in a way that the transistors of the VGA work substantially in the active region, no matter if the at least one input signal (e.g., the RF signals Vᵢₙ and V_{inb} shown in Figs. 1 and 2) that is to be amplified by the VGA is small in amplitude and a higher amplification is desired or if it is large in amplitude and a lower amplification is desired.

In the gain-control differential pair circuit, the two transistors, for instance, two MOSFETs, form a differential pair. The gain control signal may be applied to the gate of the first one of the two transistors and the fixed reference signal, e.g., an on-chip reference signal, may be applied to the gate of the other one of the two transistors. When the gain control signal becomes higher in potential than the fixed reference signal, the difference between the differential gain control voltages increases, e.g., V_{c} would become > V_{cb} in Figs. 1 and 2. In this case, a higher gain is provided by the VGA when it is controlled by the differential gain control voltages V_{c} and V_{cb}. On the other hand, when the gain control signal becomes lower in potential than the fixed reference signal, the difference between the differential gain control voltages decreases, e.g., V_{c} would become < V_{cb} in Figs. 1 and 2, such that a lower gain is provided by the VGA when it is controlled by the differential gain control voltages V_{c} and V_{cb}.

It is preferred that the common-mode adjustment circuit is adapted to adjust the common mode of the differential gain control voltages to a relatively lower value for a higher desired amplification than for a lower desired amplification. As already mentioned above, if a higher amplification is desired (e.g., because the at least one input signal that is to be amplified by the VGA is small in amplitude), then the second transistor stack needs more head-room than the first transistor stack. On the other hand, if a lower amplification is desired (e.g., because the at least one input signal that is to be amplified by the VGA is large in amplitude), then the first transistor stack needs more head-room than the second transistor stack. This can be achieved by having a lower common-mode for the differential gain control voltages in the first case, so that more of the available head-room is allocated to the second stack, and by having a higher common-mode for the differential gain control voltages in the second case, so that more of the available head-room is allocated to the first stack.

The common-mode adjustment circuit is adapted to provide a bias current equally to each of the two branches of the gain-control differential pair circuit. Since the gain-control differential pair circuit is a symmetric circuit, each of the differential gain control voltages is changed by an equal amount (and in the same direction) when the bias current is equally provided to each of the two branches of the gain-control differential pair circuit. Thus, the common-mode, which is equal to the average of the differential gain control voltages V_{c} and V_{cb}, is also changed.

The double current mirror circuit preferably comprises three transistors, for instance, three bipolar transistors or three MOSFETs. The drain and gate contacts of a first one of the three transistors are connected. If a current flows through this transistor, a gate-source voltage results. The gate contact of the first transistor is connected to the gate contacts of each of the other two transistors, such that the same gate-source voltage that is present at the first transistor is present also at each of the other two transistors. Since the dimensions (width and length of the channel) of the three transistors are substantially the same, the current that flows through each of the other two resistors is the same as the current that flows through the first transistor.

The common-mode adjustment circuit comprises another current source for providing another current, wherein the common-mode adjustment circuit is adapted to constantly provide the other current to generate a constant other part of the bias current. This allows for a constant first adjustment of the common-mode of the differential gain control voltages V_{c} and V_{cb}.

As mentioned above, the common-mode adjustment circuit comprises the current source for providing the current and a control circuit for providing the current to generate the part of the bias current in dependence of a desired amplification of the VGA. This allows adjusting the common mode of the differential gain control voltages in dependence of the desired amplification of the VGA.

It is further preferred that the control circuit comprises a switching circuit for switching the providing of the current on/off in dependence of a desired amplification of the VGA.

It is preferred that the control circuit is adapted to provide the current in dependence of the gain control signal or of the input signals, in particular, the peak of the input signals of the VGA that are to be amplified by the VGA.

In one embodiment, the control circuit comprises a comparator for comparing the gain control signal to a fixed reference signal, wherein the control circuit is adapted to provide the current to generate the part of the bias current in dependence of the output of the comparison.

In another embodiment, the control circuit comprises a Schmitt trigger having the gain control signal as input, wherein the control circuit is adapted to provide the current to generate the part of the bias current in dependence of the output of the Schmitt trigger.

In yet another embodiment, the control circuit comprises a comparator for comparing a peak of the at least one input signal that is to be amplified by the VGA to a fixed reference signal, wherein the control circuit is adapted to provide the current to generate the part of the bias current in dependence of the output of the comparison.

Preferably, the control circuit further comprises a peak detector for detecting the peak of the at least one input signal that is to be amplified by the VGA and for providing the detected peak to the comparator.

According to a further aspect of the invention, an amplification circuit is provided, comprising:
- a variable gain amplifier, VGA, and
- the gain control circuit as defined in any of claims 1 to 9 for generating differential gain control voltages and for controlling the gain of the VGA.

It is preferred that the VGA is realized by making use of a Gilbert-cell or by making use of a current-steering topology.

According to a further aspect of the invention, a gain control method for a variable gain amplifier, VGA, which comprises a first transistor stack to which at least one input signal that is to be amplified by the VGA is applied and a second transistor stack to which differential gain control voltages for controlling the gain of the VGA are applied, is presented, comprising:
- providing the differential gain control voltages, by a gain-control differential pair circuit, which comprises two branches, a first one of the two branches comprising a first one of two transistors and the other one of the two branches comprising the other one of the two transistors, the two transistors forming a differential pair, in dependence of a gain control signal applied to the first one of the two transistors, wherein a fixed reference signal is applied to the other one of the two transistors, wherein the gain-control differential pair circuit further comprises two load resistances for converting the gain control signal and the fixed reference signal into the differential gain control voltages, wherein further a source degeneration resistor for increasing the range in which the gain control signal can change the gain of the gain-control differential pair circuit is provided between the two branches of the gain-control differential pair circuit, and
- adjusting the common mode of the differential gain control voltages, by a common-mode adjustment circuit, in dependence of a desired amplification of the VGA,
wherein a bias current is provided, by a double current mirror circuit of the common-mode adjustment circuit, the double current mirror circuit comprising two further transistors, each of which is connected to a different branch of the two branches of the gain-control differential pair circuit, equally to each of the two branches of the gain-control differential pair circuit, and
wherein a current is provided, by a current source of the common-mode adjustment circuit, and the current is provided, by a control circuit of the common-mode adjustment circuit, to generate a part of the bias current in dependence of a desired amplification of the VGA.

It shall be understood that the gain control circuit for a VGA of claim 1, the amplification circuit of claim 10, and the gain control method for a VGA of claim 12 have similar and/or identical preferred embodiments, preferably, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Fig. 1 shows schematically and exemplarily a VGA as it is known in the art that is realized by making use of a Gilbert-cell,
Fig. 2 shows schematically and exemplarily another VGA as it is known in the art that is realized by making use of a current-steering topology,
Fig. 3 shows schematically and exemplarily a gain control circuit for a VGA according to an embodiment of the invention,
Fig. 4 shows schematically and exemplarily a gain control circuit for a VGA according to another embodiment of the invention,
Fig. 5 shows schematically and exemplarily a gain control circuit for a VGA according to yet another embodiment of the invention, and
Fig. 6 shows a flowchart exemplarily illustrating an embodiment of a gain control method for a VGA.

### DETAILED DESCRIPTION OF EMBODIMENTS

In the description, like elements or units are referred by like reference numerals. Moreover, if a particular element or unit or its function has been described with reference to a particular figure, the particular element or unit or its function may not be described repeatedly with reference to another figure in which it occurs.

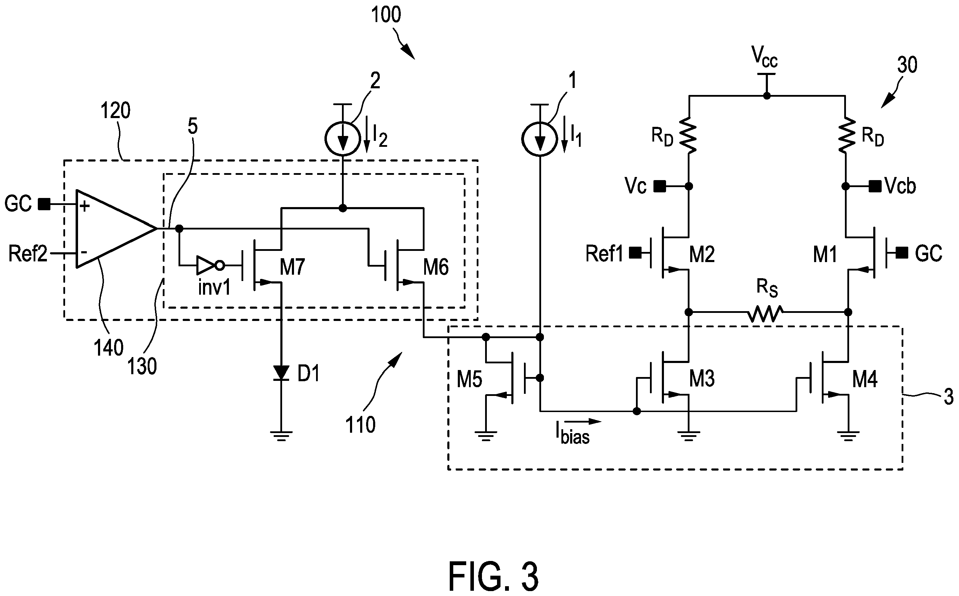

Fig. 3 shows schematically and exemplarily a gain control circuit 100 for a VGA according to an embodiment of the invention. The VGA can be a VGA as it is known in the art, for instance, it can be the VGA 10 shown in Fig. 1 that is realized by making use of a Gilbert-cell or, preferably, it can be the VGA 20 shown in Fig. 2 that is realized by making use of a current-steering topology. In any case, the VGA comprises a first transistor stack to which at least one input signal that is to be amplified by the VGA is to be applied and a second transistor stack to which differential gain control voltages for controlling the gain of the VGA are to be applied. In the following, we will assume that the VGA corresponds to the VGA 20 shown in Fig. 2. In this case, the first and the second transistor stacks correspond to the lower stack of transistors Q1 and Q2 and the upper stack of transistors Q3 to Q6 shown in Fig. 2, respectively.

The gain control circuit 100 comprises a gain-control differential pair circuit 30, which comprises two transistors M1 and M2, here, two MOSFETs, for generating the differential gain control voltages V_{c} and V_{cb} in dependence of a gain control signal GC applied to one of the two transistors, here, M1, and a common-mode adjustment circuit 110 for adjusting the common mode of the differential gain control voltages V_{c} and V_{cb} in dependence of a desired amplification of the VGA 20. As already mentioned above, this can make it possible to divide the available head-room (limited by the supply voltage V_{cc} and the common mode of the RF input signals Vᵢₙ and V_{inb}) among the first transistor stack Q1 and Q2 and the second transistor stack Q3 to Q6 in a way that the transistors Q1 to Q6 of the VGA 20 work substantially in the active region, no matter if the input signals Vᵢₙ and V_{inb} that are to be amplified by the VGA 20, here, RF signals, are small in amplitude and a higher amplification is desired or if they are large in amplitude and a lower amplification is desired.

In the gain-control differential pair circuit 30, the two transistors M1 and M2 form a differential pair. The gain control signal GC is applied to the gate of the first one M1 of the two transistors M1 and M2 and a fixed reference signal Ref1, here, an on-chip reference signal, is applied to the gate of the other one M2 of the two transistors M1 and M2. In this realization, the gain-control differential pair circuit 30 comprises two load resistances R_{D} for converting the gain control signal GC and the fixed reference signal Ref1 into the differential gain control voltages V_{c} and V_{cb}. When the gain control signal GC becomes higher in potential than the fixed reference signal Ref1, the difference between the differential gain control voltages V_{c} and V_{cb} increases. In this case, a higher gain is provided by the VGA 20 when it is controlled by the differential gain control voltages V_{c} and V_{cb}. On the other hand, when the gain control signal GC becomes lower in potential than the fixed reference signal Ref1, the difference between the differential gain control voltages V_{c} and V_{cb} decreases, such that a lower gain is provided by the VGA 20 when it is controlled by the differential gain control voltages V_{c} and V_{cb}. The resistor Rₛ is a source degeneration resistor (linearization resistor) to increase the range in which the gain control signal GC can change the gain of the gain-control differential pair circuit 30. If Rs would not be provided in the circuit, a slight change in the gain control signal GC would produce a large change in the difference between the differential gain control voltages V_{c} and V_{cb}, causing also a big change in the amplification setting. With Rₛ being provided in the circuit, the range of the gain control signal GC is increased to change the amplification setting. This means that with Rs, a small change in the gain control signal GC will produce also only a small change between the differential gain control voltages V_{c} and V_{cb} and, thus, only a small change in the amplification setting.

The common-mode adjustment circuit 110 is adapted to adjust the common mode of the differential gain control voltages V_{c} and V_{cb} to a relatively lower value for a higher desired amplification than for a lower desired amplification. Thus, if a higher amplification is desired (e.g., because the input signals Vᵢₙ and V_{inb} that are to be amplified by the VGA 20 are small in amplitude), the second transistor stack Q3-Q6 is allocated more head-room than the first transistor stack Q1 and Q2 by having a lower common-mode for the differential gain control voltages V_{c} and V_{cb}. On the other hand, if a lower amplification is desired (e.g., because the input signals Vᵢₙ and V_{inb} that are to be amplified by the VGA 20 are large in amplitude), the first transistor stack Q1 and Q2 is allocated more head-room than the second transistor stack Q3-Q6 by having a higher common-mode for the differential gain control voltages V_{c} and V_{cb}.

In this embodiment, the common-mode adjustment circuit 110 is adapted to provide a bias current I_{bias} equally to each of the two transistors M1 and M2. To this end, the common-mode adjustment circuit 110 comprises a double current mirror circuit 3, which provides the bias current I_{bias} equally to the each of the two branches of the gain-control differential pair circuit 30. Since the gain-control differential pair circuit 30 is a symmetric circuit, each of the differential gain control voltages V_{c} and V_{cb} is changed by an equal amount (and in the same direction) when the bias current I_{bias} is equally provided to each of the two branches of the gain-control differential pair circuit. Thus, the common-mode, which is equal to the average (V_{c}+V_{cb})/2 of the differential gain control voltages V_{c} and V_{cb}, is also changed.

The double current mirror circuit 3 comprises three transistors, here, three MOSFETs M3 to M5. The drain and gate contacts of a first one M5 of the three transistors are connected. If a current flows through this transistor M5, a gate-source voltage results. The gate contact of the first transistor M5 is connected to the gate contacts of each of the other two transistors M3 and M4, such that the same gate-source voltage that is present at the first transistor M5 is present also at each of the other two transistors M3 and M4. Since the dimensions (width and length of the channel) of the three transistors M3 to M5 are substantially the same, the current that flows through each of the other two resistors M3 and M4 is the same as the current that flows through the first transistor M5.

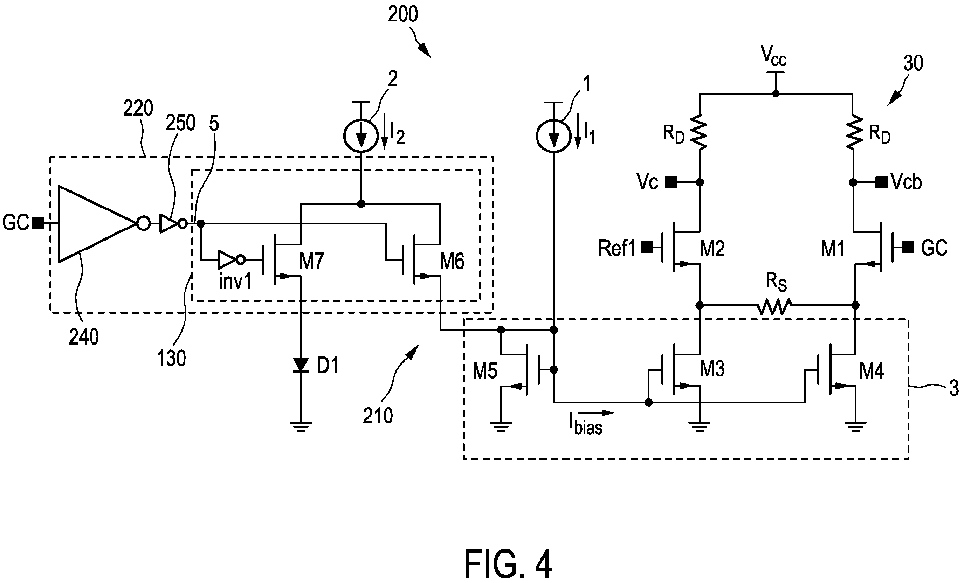

The common-mode adjustment circuit 110, here, comprises a first current source 1 for providing a first current I₁. The common-mode adjustment circuit 110 is adapted to constantly provide the first current I₁ to generate a constant first part of the bias current I_{bias}. This allows for a constant first adjustment of the common-mode of the differential gain control voltages V_{c} and V_{cb}. As can be seen from Fig. 4, the first current I₁ from the first current source 1 flows into the first transistor M5 of the double current mirror circuit 3.

In order to adjust the common mode of the differential gain control voltages V_{c} and V_{cb} in dependence of the desired amplification of the VGA 20, the common-mode adjustment circuit 110 further comprises a second current source 2 for providing a second current I₂ and a control circuit 120 for providing the second current I₂ to generate a second part of the bias current I_{bias} in dependence of a desired amplification of the VGA 20. Here, the control circuit 120 comprises a switching circuit 130 for switching the providing of the second current I₂ on/off in dependence of a desired amplification of the VGA. The switching circuit 130 is realized in this embodiment as a transmission gate selector. It comprises an inverter inv1, a first transistor M6 and a second transistor M7. Both transistors M6 and M7 are connected with their source to the second current source 2. However, while the drain of the first transistor M6 is connected to the first transistor M5 of the double current mirror circuit 3, the drain of the second transistor M7 is connected to a diode D1, which in turn is connected to ground. The switching circuit 130 further comprises a selection signal input 5, which is directly connected to the gate of the first transistor M6 and connected via the inverter inv1 to the second transistor M7. The switching circuit 130 is configured to allow the second current I₂ to pass through the first transistor M6 to the first transistor M5 of the double current mirror circuit 3 in response to the selection signal input 5 being driven high (logic one). In contrast, if the selection signal input 5 is driven low (logic zero), the second current I₂ pass through the second transistor M6 to the diode D1.

In this embodiment, the selection signal input 5 is driven in dependence of the gain control signal GC. In particular, the control circuit 120 comprises a comparator 140, here, an operational amplifier (OpAmp), for comparing the gain control signal GC to a fixed reference signal Ref2. The control circuit 120 is adapted to provide the second current I₂ to generate the second part of the bias current I_{bias} in dependence of the output of the comparison. If the gain control signal GC is higher than the fixed reference signal Ref2, the output of the comparator 140 is high (i.e., the selection signal input 5 is driven high) and, consequently, the first transistor M6 of the switching circuit 130 is turned on and directs the second current I₂ to the first transistor M5 of the double current mirror circuit 3. This results in an increased voltage drop across the two load resistances R_{D} of the gain-control differential pair circuit 30 and, consequently, a lower common-mode (V_{c}+V_{cb})/2 of the differential gain control voltages V_{c} and V_{cb}. As already mentioned above, this is beneficial if the input signals Vᵢₙ and V_{inb} that are to be amplified by the VGA 20 are small in amplitude and, thus, need a higher amplification, since it gives more head-room for the second transistor stack Q3 to Q6 of the VGA 20.

On the other hand, if the input signals Vᵢₙ and V_{inb} that are to be amplified by the VGA 20 are large in amplitude, a smaller gain is required. This can be achieved by reducing the gain control signal GC to a value that is lower than the fixed reference signal Ref2. In this case, the output of the comparator 140 is low (i.e., the selection signal input 5 is driven low) and, consequently, the first transistor M6 of the switching circuit 130 is turned off, reducing the current that flows into the first transistor M5 of double current mirror circuit 3 to only the first current I₁ instead of the sum I₁+I₂ of the first current I₁ and the second current I₂. As a result, a smaller voltage drop occurs across the two load resistances R_{D}. The common-mode (V_{c}+V_{cb})/2 of the differential gain control voltages V_{c} and V_{cb} in this case goes up in potential, giving more head-room for the first transistor stack Q1 and Q2 of the VGA 20.

Fig. 4 shows schematically and exemplarily a gain control circuit 200 for a VGA according to another embodiment of the invention. Again, the VGA can be a VGA as it is known in the art, for instance, it can be the VGA 10 shown in Fig. 1 that is realized by making use of a Gilbert-cell or, preferably, it can be the VGA 20 shown in Fig. 2 that is realized by making use of a current-steering topology.

The gain control circuit 200 is substantially the same as the gain control circuit 100 shown in Fig. 3. However, instead of the comperator 140 that is used in the gain control circuit 100, a Schmitt trigger 240 having the gain control signal GC as input is used in the control circuit 220 of the common-mode adjustment circuit 210 of the gain control circuit 200. The control circuit 220 is then adapted to provide the second current I2 to generate the second part of the bias current (I_{bias}) in dependence of the output of the Schmitt trigger 240. The underlying idea is that, instead of using a comparator with a fixed reference signal, an inverter is used that has an asymmetric input-output transfer function (i.e., a Schmitt trigger) obtained by sizing the NMOS and PMOS transistors inside the inverter 240 such that the inverter threshold is located either closer to the ground or closer to the supply voltage V_{cc}, which is equivalent to moving the reference signal Ref2 in Fig. 3 closer to ground or closer to the supply voltage V_{cc}. Such a Schmitt trigger, which is used here together with an additional, "normal" inverter 250, is described, for instance, in M. Steyaert and W. Sansen, "Novel CMOS Schmitt trigger," Electronics Letters, Vol. 22, No. 4, pages 203 to 204, February 1986, the content of which is incorporated herein in its entirety. If the VGA 20 is embedded inside an automatic gain control (AGC) loop, a hysteresis can be used inside the Schmitt trigger 240 to avoiding frequent switching in the common-mode (V_{c}+V_{cb})/2 of the differential gain control voltages V_{c} and V_{cb} due to the noise on gain control signal GC.

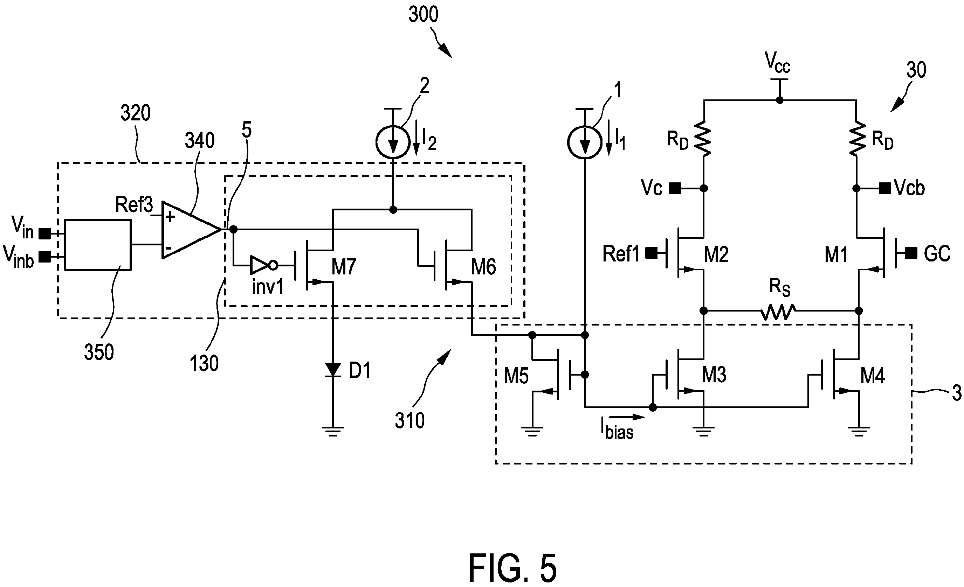

Fig. 5 shows schematically and exemplarily a gain control circuit 300 for a VGA according to yet another embodiment of the invention. Again, the VGA can be a VGA as it is known in the art, for instance, it can be the VGA 10 shown in Fig. 1 that is realized by making use of a Gilbert-cell or, preferably, it can be the VGA 20 shown in Fig. 2 that is realized by making use of a current-steering topology.

The gain control circuit 200 is substantially the same as the gain control circuit 100 shown in Fig. 3. However, instead of the comperator 140 that is used in the gain control circuit 100 and that compares the gain control signal GC to a fixed reference signal Ref2, a comparator 340, here, an operational amplifier (OpAmp), for comparing a peak of the input signals Vᵢₙ and V_{inb} that are to be amplified by the VGA 20 to a fixed reference signal Ref3 is used in the control circuit 320 of the common-mode adjustment circuit 310 of the gain control circuit 300. To this end, the control circuit 320 further comprises a peak detector 350 for detecting the peak of the input signals Vᵢₙ and V_{inb} that are to be amplified by the VGA 20 and for providing the detected peak to the comparator 340. The control circuit 320 is adapted to provide the second current I₂ to generate the second part of the bias current I_{bias} in dependence of the output of the comparison. In more detail, the peak detector 350 provides a DC output signal that is proportional to the amplitude of the input signals Vᵢₙ and V_{inb} that are to be amplified by the VGA 20. If the input amplitude is low, the output signal of the peak detector 350 falls below the fixed reference signal Ref2 in potential and, consequently, the output of the comperator 340 is high. In contrast, if the input amplitude is high, the output signal of the peak detector 350 becomes higher in potential than the fixed reference signal Ref2 and, consequently, the output of the comperator 340 is low.

As described with reference to Fig. 2, if the selection signal input 5 is driven high (i.e., the output of the comperator 340 is high), the first transistor M6 of the switching circuit 130 is turned on and directs the second current I₂ to the first transistor M5 of the double current mirror circuit 3, which results in an increased voltage drop across the two load resistances R_{D} of the gain-control differential pair circuit 30 and, consequently, a lower common-mode (V_{c}+V_{cb})/2 of the differential gain control voltages V_{c} and V_{cb}. On the other hand, if the selection signal input 5 is driven low (i.e., output of the comparator 340 is low), the first transistor M6 of the switching circuit 130 is turned off, reducing the current that flows into the first transistor M5 of double current mirror circuit 3 to only the first current I₁ instead of the sum I₁+I₂ of the first current I₁ and the second current I₂. As a result, a smaller voltage drop occurs across the two load resistances R_{D}, wherefore the common-mode (V_{c}+V_{cb})/2 of the differential gain control voltages V_{c} and V_{cb} goes up in potential.

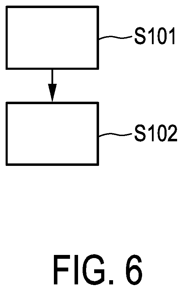

Fig. 6 shows a flowchart exemplarily illustrating an embodiment of a gain control method for a VGA. The method can preferably be performed with any of the gain control circuits 100, 200 and 300 described with reference to Figs. 3 to 5 above. Again, the VGA can be a VGA as it is known in the art, for instance, it can be the VGA 10 shown in Fig. 1 that is realized by making use of a Gilbert-cell or, preferably, it can be the VGA 20 shown in Fig. 2 that is realized by making use of a current-steering topology.

In step S101, the differential gain control voltages V_{c} and V_{cb} are provided, by a gain-control differential pair circuit 30, which comprises two transistors M1 and M2, in dependence of a gain control signal GC applied to one of the two transistors M1 and M2.

In step S102, the common mode of the differential gain control voltages V_{c} and V_{cb} is adjusted, by a common-mode adjustment circuit 110, 120, 130, in dependence of a desired amplification of the VGA 10 or 20, for instance, in dependence of the gain control signal GC, as in the gain control circuits 100 and 200 or of the input signals Vᵢₙ and V_{inb}, in particular, the peak of the input signals Vᵢₙ and V_{inb} of the VGA 10 or 20 that are to be amplified by the VGA 10 or 20.

Other variations to the disclosed embodiments can be understood and affected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

Any reference signs in the claims should not be construed as limiting the scope.

Although the VGAs 10 and 20 have been described above with reference to Figs. 1 and 2, respectively, as being build with bipolar transistors Q1 to Q6, they can also be built with MOSFETs instead. The above explanations regarding the head-room apply also to realizations based on MOSFETs.

Although in the embodiments of the gain control circuit 100, 200 and 300 described with reference to Figs. 3 to 5 above, the transistors M1 and M2 of the gain-control differential pair circuit 30 are MOSFETs, they can also be replaced by bipolar transistors. Also, the MOSFETs M3 to M5 in the double current mirror 3 and the MOSFETs M6 and M7 in the switching circuit 130 can be replaced by bipolar transistors. Moreover, the OpAmps that are used as the comparators 140 and 340 can be bipolar OpAmps.

## Claims

1. A gain control circuit (100; 200; 300) for a variable gain amplifier, VGA, (10; 20), which comprises a first transistor stack (Q1, Q2) to which at least one input signal (Vᵢₙ, V_{inb}) that is to be amplified by the VGA (10; 20) is to be applied and a second transistor stack (Q3-Q6) to which differential gain control voltages (V_{c}, V_{cb}) for controlling the gain of the VGA (10; 20) are to be applied, the gain control circuit comprising:
- a gain-control differential pair circuit (30), which comprises two branches, a first one of the two branches comprising a first one of two transistors and the other one of the two branches comprising the other one of the two transistors, the two transistors (M1, M2) forming a differential pair, for generating the differential gain control voltages (V_{c}, V_{cb}) in dependence of a gain control signal (GC) applied to the first one of the two transistors (M1), wherein a fixed reference signal (Ref1) is applied to the other one of the two transistors (M2), wherein the gain-control differential pair circuit (30) further comprises two load resistances (R_{D}) for converting the gain control signal (GC) and the fixed reference signal (Ref1) into the differential gain control voltages (V_{c}, V_{cb}), wherein further a source degeneration resistor (Rs) for increasing the range in which the gain control signal (GC) can change the gain of the gain-control differential pair circuit (30) is provided between the two branches of the gain-control differential pair circuit (30), and **characterised by** the gain control circuit further comprising:
- a common-mode adjustment circuit (110; 210; 310) for adjusting the common mode of the differential gain control voltages (V_{c}, V_{cb}) in dependence of a desired amplification of the VGA (10; 20),
wherein the common-mode adjustment circuit (110; 210; 310) comprises a double current mirror circuit (3) comprising two further transistors (M3, M4), each of which is connected to a different branch of the two branches of the gain-control differential pair circuit (30), for providing a bias current (I_{bias}) equally to each of the two branches of the gain-control differential pair circuit (30), and
wherein the common-mode adjustment circuit (110; 210; 310) comprises a current source (2) for providing a current (I₂) and a control circuit (120; 220; 320) for providing the current (I₂) to generate a part of the bias current (I_{bias}) in dependence of a desired amplification of the VGA (10; 20).

2. The gain control circuit (100; 200; 300) as defined in claim 1, wherein the common-mode adjustment circuit (110; 210; 310) is adapted to adjust the common mode of the differential gain control voltages (V_{c}, V_{cb}) to a relatively lower value for a higher desired amplification than for a lower desired amplification.

3. The gain control circuit (100; 200; 300) as defined in claim 1 or 2, wherein the common-mode adjustment circuit (110; 210; 310) comprises another current source (1) for providing another current (I₁), wherein the common-mode adjustment circuit (110; 210; 310) is adapted to constantly provide the other current (I₁) to generate a constant other part of the bias current (I_{bias}).

4. The gain control circuit (100; 200; 300) as defined in claim 1, wherein the control circuit (120; 220; 320) comprises a switching circuit (130) for switching the providing of the current (I₂) on/off in dependence of a desired amplification of the VGA (10; 20).

5. The gain control circuit (100; 200; 300) as defined in any of claims 1 to 4, wherein the control circuit (120; 220; 320) is adapted to provide the current (I₂) in dependence of the gain control signal (GC) or of the input signals (Vᵢₙ, V_{inb}), in particular, the peak of the input signals (Vᵢₙ, V_{inb}) of the VGA (10; 20) that are to be amplified by the VGA (10; 20).

6. The gain control circuit (100; 200; 300) as defined in any of claims 1 to 5, wherein the control circuit (120) comprises a comparator (140) for comparing the gain control signal (GC) to a fixed reference signal (Ref2), wherein the control circuit (120) is adapted to provide the current (I₂) to generate the part of the bias current (I_{bias}) in dependence of the output of the comparison.

7. The gain control circuit (100; 200; 300) as defined in any of claims 1 to 6, wherein the control circuit (220) comprises a Schmitt trigger (240) having the gain control signal (GC) as input, wherein the control circuit (220) is adapted to provide the current (I₂) to generate the part of the bias current (I_{bias}) in dependence of the output of the Schmitt trigger (240).

8. The gain control circuit (100; 200; 300) as defined in any of claims 1 to 6, wherein the control circuit (320) comprises a comparator (340) for comparing a peak of the at least one input signal (Vᵢₙ, V_{inb}) that is to be amplified by the VGA (10; 20) to a fixed reference signal (Ref3), wherein the control circuit (320) is adapted to provide the current (I₂) to generate the part of the bias current (I_{bias}) in dependence of the output of the comparison.

9. The gain control circuit (100; 200; 300) as defined in claim 8, wherein the control circuit (320) further comprises a peak detector (350) for detecting the peak of the at least one input signal (Vᵢₙ, V_{inb}) that is to be amplified by the VGA (10; 20) and for providing the detected peak to the comparator (340).

10. An amplification circuit, comprising:
- a variable gain amplifier, VGA, (10; 20), and
- the gain control circuit (100; 200; 300) as defined in any of claims 1 to 9 for generating the differential gain control voltages (V_{c}, V_{cb}) and for controlling the gain of the VGA (10; 20).

11. The amplification circuit as defined in claim 10, wherein the VGA (10; 20) is realized by making use of a Gilbert-cell or by making use of a current-steering topology.

12. A gain control method for a variable gain amplifier, VGA, (10; 20), which comprises a first transistor stack (Q1, Q2) to which at least one input signal (Vᵢₙ, V_{inb}) that is to be amplified by the VGA (10; 20) is applied and a second transistor stack (Q3-Q6) to which differential gain control voltages (V_{c}, V_{cb}) for controlling the gain of the VGA (10; 20) are applied, comprising:
- providing the differential gain control voltages (V_{c}, V_{cb}), by a gain-control differential pair circuit (30), which comprises two branches, a first one of the two branches comprising a first one of two transistors and the other one of the two branches comprising the other one of the two transistors, the two transistors (M1, M2) forming a differential pair, in dependence of a gain control signal (GC) applied to the first one of the two transistors (M1, M2), wherein a fixed reference signal (Ref1) is applied to the other one of the two transistors (M2), wherein the gain-control differential pair circuit (30) further comprises two load resistances (R_{D}) for converting the gain control signal (GC) and the fixed reference signal (Ref1) into the differential gain control voltages (V_{c}, V_{cb}), wherein further a source degeneration resistor (Rs) for increasing the range in which the gain control signal (GC) can change the gain of the gain-control differential pair circuit (30) is provided between the two branches of the gain-control differential pair circuit (30), and **characterised by** further comprising:
- adjusting the common mode of the differential gain control voltages (V_{c}, V_{cb}), by a common-mode adjustment circuit (110; 120; 130), in dependence of a desired amplification of the VGA,
wherein a bias current (I_{bias}) is provided, by a double current mirror circuit (3) of the common-mode adjustment circuit (110; 210; 310), the double current mirror circuit (3) comprising two further transistors (M3, M4), each of which is connected to a different branch of the two branches of the gain-control differential pair circuit (30), equally to each of the two branches of the gain-control differential pair circuit (30), and
wherein a current (I₂) is provided, by a current source (2) of the common-mode adjustment circuit (110; 210; 310), and the current (I₂) is provided, by a control circuit (120; 220; 320) of the common-mode adjustment circuit (110; 210; 310), to generate a part of the bias current (I_{bias}) in dependence of a desired amplification of the VGA (10; 20).

## Patentansprüche

1. Verstärkungssteuerschaltung (100; 200; 300) für einen Verstärker mit variabler Verstärkung, VGA, (10; 20), die einen ersten Transistorstapel (Q1, Q2), an den mindestens ein Eingangssignal (Vᵢₙ, V_{inb}), das durch den VGA (10; 20) verstärkt werden soll, angelegt werden soll, und einen zweiten Transistorstapel (Q3-Q6), an den differentielle Verstärkungssteuerspannungen (V_{c}, V_{cb}) zum Steuern der Verstärkung des VGA (10; 20) angelegt werden sollen, wobei die Verstärkungssteuerschaltung umfasst:
- eine Verstärkungssteuerungsdifferentialpaarschaltung (30), die zwei Zweige umfasst, wobei ein erster der zwei Zweige einen ersten von zwei Transistoren und der andere der zwei Zweige den anderen der zwei Transistoren umfasst, wobei die zwei Transistoren (M1, M2) ein Differentialpaar bilden, zum Erzeugen der differentiellen Verstärkungssteuerspannungen (V_{c}, V_{cb}) in Abhängigkeit von einem an den ersten der zwei Transistoren (M1) angelegten Verstärkungssteuersignal (GC), wobei an den anderen der zwei Transistoren (M2) ein festes Referenzsignal (Ref1) angelegt wird, wobei die Verstärkungssteuerungsdifferentialpaarschaltung (30) des Weiteren zwei Lastwiderstände (R_{D}) zum Umwandeln des Verstärkungssteuersignals (GC) und des festen Referenzsignals (Ref1) in die differentiellen Verstärkungssteuerspannungen (V_{c}, V_{cb}) umfasst, wobei des Weiteren ein Quellendegenerationswiderstand (Rs) zum Vergrößern des Bereichs, in dem das Verstärkungssteuersignal (GC) die Verstärkung der Verstärkungssteuerungsdifferentialpaarschaltung (30) verändern kann, zwischen den zwei Zweigen der Verstärkungssteuerungsdifferentialpaarschaltung (30) vorgesehen ist, und
- eine Gleichtakteinstellschaltung (110; 210; 310) zum Einstellen des Gleichtakts der differentiellen Verstärkungssteuerspannungen (V_{c}, V_{cb}) in Abhängigkeit von einer gewünschten Verstärkung des VGA (10; 20),
wobei die Gleichtakteinstellschaltung (110; 210; 310) eine Doppelstromspiegelschaltung (3) umfasst, die zwei weitere Transistoren (M3, M4) umfasst, von denen jeder mit einem anderen Zweig der zwei Zweige der Verstärkungssteuerungsdifferentialpaarschaltung (30) verbunden ist, zum Bereitstellen eines Vorspannungsstroms (I_{bias}) gleichermaßen an jedem der zwei Zweige der Verstärkungssteuerungsdifferentialpaarschaltung (30), und
wobei die Gleichtakteinstellschaltung (110; 210; 310) eine Stromquelle (2) zum Bereitstellen eines Stroms (I₂) umfasst sowie eine Steuerschaltung (120; 220; 320) zum Bereitstellen des Stroms (I₂), um einen Teil des Vorspannungsstroms (I_{bias}) in Abhängigkeit von einer gewünschten Verstärkung des VGA (10; 20) zu erzeugen.

2. Verstärkungssteuerungsschaltung (100; 200; 300) nach Anspruch 1, wobei die Gleichtakteinstellschaltung (110; 210; 310) angepasst ist, um den Gleichtakt der differentiellen Verstärkungssteuerspannungen (V_{c}, V_{cb}) auf einen relativ niedrigeren Wert für eine höhere gewünschte Verstärkung als für eine niedrigere gewünschte Verstärkung einzustellen.

3. Verstärkungssteuerungsschaltung (100; 200; 300) nach Anspruch 1 oder 2, wobei die Gleichtakteinstellschaltung (110; 210; 310) eine weitere Stromquelle (1) zum Bereitstellen eines weiteren Stroms (I₁) umfasst, wobei die Gleichtakteinstellschaltung (110; 210; 310) angepasst ist, um den weiteren Strom (I₁) konstant bereitzustellen, um einen konstanten weiteren Teil des Vorspannungsstroms (I_{bias}) zu erzeugen.

4. Verstärkungssteuerschaltung (100; 200; 300) nach Anspruch 1, wobei die Steuerschaltung (120; 220; 320) einen Schaltkreis (130) zum Ein-/Ausschalten des Bereitstellens des Stroms (I₂) in Abhängigkeit von einer gewünschten Verstärkung des VGA (10; 20) umfasst.

5. Verstärkungssteuerschaltung (100; 200; 300) nach einem der Ansprüche 1 bis 4, wobei die Steuerschaltung (120; 220; 320) ausgebildet ist, um den Strom (I₂) in Abhängigkeit von dem Verstärkungssteuersignal (GC) oder von den Eingangssignalen (Vᵢₙ, V_{inb}), insbesondere der Spitze der von dem VGA (10; 20) zu verstärkenden Eingangssignale (Vᵢₙ, V_{inb}) des VGA (10; 20) bereitzustellen.

6. Verstärkungssteuerschaltung (100; 200; 300) nach einem der Ansprüche 1 bis 5, wobei die Steuerschaltung (120) einen Vergleicher (140) zum Vergleichen des Verstärkungssteuersignals (GC) mit einem festen Referenzsignal (Ref2) umfasst, wobei die Steuerschaltung (120) ausgebildet ist, um den Strom (I₂) zum Erzeugen des Teils des Vorspannungsstroms (I_{bias}) in Abhängigkeit von dem Ausgang des Vergleichs bereitzustellen.

7. Verstärkungssteuerschaltung (100; 200; 300) nach einem der Ansprüche 1 bis 6, wobei die Steuerschaltung (220) einen Schmitt-Trigger (240) umfasst, der das Verstärkungssteuersignal (GC) als Eingang hat, wobei die Steuerschaltung (220) angepasst ist, um den Strom (I₂) zum Erzeugen des Teils des Vorspannungsstroms (I_{bias}) in Abhängigkeit von der Ausgabe des Schmitt-Triggers (240) bereitzustellen.

8. Verstärkungssteuerungsschaltung (100; 200; 300) nach einem der Ansprüche 1 bis 6, wobei die Steuerschaltung (320) einen Vergleicher (340) zum Vergleichen einer Spitze des mindestens einen Eingangssignals (Vᵢₙ, V_{inb}), das durch den VGA (10; 20) verstärkt werden soll, mit einem festen Referenzsignal (Ref3) umfasst, wobei die Steuerschaltung (320) angepasst ist, um den Strom (I₂) zum Erzeugen des Teils des Vorspannungsstroms (I_{bias}) in Abhängigkeit von dem Ausgang des Vergleichs bereitzustellen.

9. Verstärkungssteuerschaltung (100; 200; 300) nach Anspruch 8, wobei die Steuerschaltung (320) des Weiteren einen Spitzenwertdetektor (350) zum Erfassen des Spitzenwerts des mindestens einen Eingangssignals (Vᵢₙ, V_{inb}), das durch den VGA (10; 20) verstärkt werden soll, und zum Bereitstellen des erfassten Spitzenwerts an den Vergleicher (340) umfasst.

10. Verstärkerschaltung, umfassend:
- einen Verstärker mit variabler Verstärkung, VGA, (10; 20), und
- die Verstärkungssteuerschaltung (100; 200; 300) nach einem der Ansprüche 1 bis 9 zum Erzeugen der differentiellen Verstärkungssteuerspannungen (V_{c}, V_{cb}) und zum Steuern der Verstärkung des VGA (10; 20).

11. Verstärkungsschaltung nach Anspruch 10, wobei der VGA (10; 20) unter Verwendung einer Gilbert-Zelle oder unter Verwendung einer stromsteuernden Topologie realisiert ist.

12. Verfahren zur Verstärkungssteuerung für einen Verstärker mit variabler Verstärkung, VGA, (10; 20), der einen ersten Transistorstapel (Q1, Q2), an den mindestens ein Eingangssignal (Vᵢₙ, V_{inb}), das durch den VGA (10; 20) verstärkt werden soll, angelegt wird, und einen zweiten Transistorstapel (Q3-Q6), an den differentielle Verstärkungssteuerspannungen (Vc, Vcb) zum Steuern der Verstärkung des VGA (10; 20) angelegt werden, umfassend:
- Erzeugen der differentiellen Verstärkungssteuerspannungen (V_{c}, V_{cb}) durch eine Verstärkungssteuerungsdifferentialpaarschaltung (30), die zwei Zweige umfasst, wobei ein erster der zwei Zweige einen ersten von zwei Transistoren und der andere der zwei Zweige den anderen der zwei Transistoren umfasst, wobei die zwei Transistoren (M1, M2) ein Differentialpaar bilden, in Abhängigkeit von einem an einen ersten der zwei Transistoren (M1, M2) angelegten Verstärkungssteuersignal (GC), wobei an den anderen der zwei Transistoren (M2) ein festes Referenzsignal (Ref1) angelegt wird, wobei die Verstärkungssteuerungsdifferentialpaarschaltung (30) des Weiteren zwei Lastwiderstände (R_{D}) zum Umwandeln des Verstärkungssteuersignals (GC) und des festen Referenzsignals (Ref1) in die differentiellen Verstärkungssteuerspannungen (V_{c}, V_{cb}) umfasst, wobei des Weiteren ein Quellendegenerationswiderstand (Rs) zum Vergrößern des Bereichs, in dem das Verstärkungssteuersignal (GC) die Verstärkung der Verstärkungssteuerungsdifferentialpaarschaltung (30) ändern kann, zwischen den zwei Zweigen der Verstärkungssteuerungsdifferentialpaarschaltung (30) vorgesehen ist, und
- Einstellen des Gleichtakts der differentiellen Verstärkungssteuerspannungen (V_{c}, V_{cb}) durch eine Gleichtakteinstellschaltung (110; 120; 130) in Abhängigkeit von einer gewünschten Verstärkung des VGA,
wobei ein Vorspannungsstrom (I_{bias}) bereitgestellt wird, durch eine Doppelstromspiegelschaltung (3) der Gleichtakteinstellschaltung (110; 210; 310), wobei die Doppelstromspiegelschaltung (3) zwei weitere Transistoren (M3, M4) umfasst, von denen jeder mit einem anderen Zweig der zwei Zweige der Verstärkungssteuerungsdifferentialpaarschaltung (30) verbunden ist, gleichermaßen an jedem der zwei Zweige der Verstärkungssteuerungsdifferentialpaarschaltung (30), und
wobei ein Strom (I₂) von einer Stromquelle (2) der Gleichtakteinstellschaltung (110; 210; 310) bereitgestellt wird, und der Strom (I₂) von einer Steuerschaltung (120; 220; 320) der Gleichtakteinstellschaltung (110; 210; 310) bereitgestellt wird, um einen Teil des Vorspannungsstroms (I_{bias}) in Abhängigkeit von einer gewünschten Verstärkung des VGA (10; 20) zu erzeugen.

## Revendications

1. Circuit de commande de gain (100 ; 200 ; 300) pour un amplificateur à gain variable, VGA, (10 ; 20), qui comprend un premier empilement de transistors (Q1, Q2) auquel au moins un signal d'entrée (Vᵢₙ, V_{inb}) qui est à amplifier par le VGA (10 ; 20) est à appliquer et un deuxième empilement de transistors (Q3-Q6) auquel des tensions différentielles de commande de gain (V_{c}, V_{cb}) pour commander le gain du VGA(10; 20) sont à appliquer, le circuit de commande de gain comprenant :
- un circuit à paire différentielle de commande de gain (30), qui comprend deux branches, une première des deux branches comprenant un premier de deux transistors et l'autre des deux branches comprenant l'autre des deux transistors, les deux transistors (M1, M2) formant une paire différentielle, pour générer les tensions différentielles de commande de gain (V_{c}, V_{cb}) en fonction d'un signal de commande de gain (GC) appliqué au premier parmi les deux transistors (M1), dans lequel un signal formant une référence fixe (Ref 1) est appliqué à l'autre parmi les deux transistors (M2), dans lequel le circuit à paire différentielle de commande de gain (30) comprend en outre deux résistances de charge (R_{D}) pour convertir le signal de commande de gain (GC) et le signal formant une référence fixe (Ref 1) dans les tensions différentielles de commande de gain (V_{c}, V_{cb}), dans lequel en outre une résistance de dégénérescence de source (Rₛ) pour augmenter la plage dans laquelle le signal de commande de gain (GC) peut modifier le gain du circuit à paire différentielle de commande de gain (30) est fourni entre les deux branches du circuit à paire différentielle de commande de gain (30), et **caractérisé en ce que** le circuit de commande de gain comprend en outre :
un circuit de réglage de mode commun (110; 210 ; 310) pour régler le mode commun des tensions différentielles de commande de gain (V_{c}, V_{cb}) en fonction d'une amplification souhaitée du VGA (10 ; 20),
dans lequel le circuit de réglage de mode commun (110 ; 210 ; 310) comprend un circuit formant miroir de courant double (3) comprenant deux autres transistors (M3, M4), dont chacun est connecté à une branche différente des deux branches du circuit à paire différentielle de commande de gain (30), pour fournir un courant de polarisation (I_{bias}) de façon égale à chacune des deux branches du circuit à paire différentielle de commande de gain (30), et
dans lequel le circuit de réglage de mode commun (110 ; 210 ; 310) comprend une source de courant (2) pour fournir un courant (I₂) et un circuit de commande (I20 ; 220 ; 320) pour fournir le courant (I₂) pour générer une partie du courant de polarisation (I_{bias}) en fonction d'une amplification souhaitée du VGA (10 ; 20).

2. Circuit de commande de gain (100 ; 200 ; 300) selon la revendication 1, dans lequel le circuit de réglage de mode commun (110 ; 210 ; 310) est adapté pour régler le mode commun des tensions différentielles de commande de gain (V_{c}, V_{cb}) à une valeur relativement plus faible pour une amplification souhaitée plus élevée que pour une amplification souhaitée plus faible.

3. Circuit de commande de gain (100 ; 200 ; 300) selon la revendication 1 ou 2, dans lequel le circuit de réglage de mode commun (110 ; 210 ; 310) comprend une autre source de courant (1) pour fournir un autre courant (I1), dans lequel le circuit de réglage de mode commun (110 ; 210 ; 310) est adapté pour fournir en permanence l'autre courant (I1) pour générer une autre partie constante du courant de polarisation (I_{bias}).

4. Circuit de commande de gain (100 ; 200 ; 300) selon la revendication 1, dans lequel le circuit de commande (I20 ; 220 ; 320) comprend un circuit de commutation (130) pour commuter la fourniture du courant (I₂) en fonction d'une amplification souhaitée du VGA (10 ; 20).

5. Circuit de commande de gain (100 ; 200 ; 300) selon l'une quelconque des revendications 1 à 4, dans lequel le circuit de commande (I20 ; 220 ; 320) est adapté pour fournir le courant (I₂) en fonction du signal de commande de gain. (GC) ou des signaux d'entrée (Vᵢₙ, V_{inb}), en particulier la crête des signaux d'entrée (Vᵢₙ, V_{inb}) du VGA (10 ; 20) qui doivent être amplifiés par le VGA (10 ; 20).

6. Circuit de commande de gain (100 ; 200 ; 300) selon l'une quelconque des revendications 1 à 5, dans lequel le circuit de commande (I20) comprend un comparateur (140) pour comparer le signal de commande de gain (GC) à un signal de référence fixe (Ref 2), dans lequel le circuit de commande (I20) est adapté pour fournir le courant (I₂) pour générer la partie du courant de polarisation (I_{bias}) en fonction de la sortie de la comparaison.

7. Circuit de commande de gain (100 ; 200 ; 300) selon l'une quelconque des revendications 1 à 6, dans lequel le circuit de commande (220) comprend une bascule de Schmitt (240) ayant le signal de commande de gain (GC) comme entrée, dans lequel le circuit de commande (220) est adapté pour fournir le courant (I₂) pour générer la partie du courant de polarisation (I_{bias}) en fonction de la sortie de la bascule de Schmitt (240).

8. Circuit de commande de gain (100 ; 200 ; 300) selon l'une quelconque des revendications 1 à 6, dans lequel le circuit de commande (320) comprend un comparateur (340) pour comparer une crête du au moins un signal d'entrée (Vᵢₙ, V_{inb}) qui doit être amplifié par le VGA (10 ; 20) à un signal de référence fixe (Ref 3), dans lequel le circuit de commande (320) est adapté pour fournir le courant (I₂) pour générer la partie du courant de polarisation (I_{bias}) en fonction de la sortie de la comparaison.

9. Circuit de commande de gain (100 ; 200 ; 300) selon la revendication 8, dans lequel le circuit de commande (320) comprend en outre un détecteur de crête (350) pour détecter la crête de l'au moins un signal d'entrée (Vᵢₙ, V_{inb}) qui doit être amplifié par le VGA (10 ; 20) et pour fournir la crête détectée au comparateur (340).

10. Un circuit d'amplification, comprenant :
- un amplificateur à gain variable, VGA, (10 ; 20), et
- le circuit de commande de gain (100 ; 200 ; 300) tel que défini dans l'une quelconque des revendications 1 à 9 pour générer les tensions différentielles de commande de gain (V_{c}, V_{cb}) et pour commander le gain du VGA (10; 20).

11. Circuit d'amplification selon la revendication 10, dans lequel le VGA (10 ; 20) est réalisé en utilisant une cellule de Gilbert ou en utilisant une topologie de pilotage de courant.

12. Un procédé de contrôle de gain pour un amplificateur à gain variable, VGA, (10; 20), qui comprend un premier empilement de transistors (Q1, Q2) auquel au moins un signal d'entrée (Vᵢₙ, V_{inb}) qui doit être amplifié par le VGA (10 ; 20) est appliqué et un deuxième empilement de transistors (Q3-Q6) auquel les tensions différentielles de commande de gain (V_{c}, V_{cb}) pour commander le gain du VGA (10 ; 20) sont appliquées, comprenant les étapes consistant à :
fournir les tensions différentielles de commande de gain (V_{c}, V_{cb}), par un circuit à paire différentielle de commande de gain (30), qui comprend deux branches, une première des deux branches comportant un premier de deux transistors et l'autre l'un des deux branches comprenant l'autre des deux transistors, les deux transistors (M1, M2) formant une paire différentielle, en fonction d'un signal de commande de gain (GC) appliqué au premier des deux transistors (M1, M2), dans lequel un signal de référence fixe (Ref 1) est appliqué à l'autre des deux transistors (M2), dans lequel le circuit à paire différentielle de commande de gain (30) comprend en outre deux résistances de charge (RD) pour convertir le signal de commande de gain (GC) et le signal de référence fixe (Ref 1) dans les tensions différentielles de commande de gain (V_{c}, V_{cb}), dans lequel en outre une résistance de dégénérescence de source (Rs) pour augmenter la plage dans laquelle le signal de commande de gain (GC) peut modifier le gain du circuit à paire différentielle de commande de gain (30) est fourni entre les deux branches du circuit à paire différentielle de commande de gain (30), et **caractérisé en ce qu'**il comprend en outre les étapes consistant à :
régler les tensions différentielles de commande de gain (V_{c}, V_{cb}), par un circuit de réglage de mode commun (110; I20 ; 130), en fonction d'une amplification souhaitée du VGA,
dans lequel un courant de polarisation (I_{bias}) est fourni par un circuit formant miroir de courant double (3) du circuit de réglage de mode commun (110 ; 210 ; 310), le circuit formant miroir de courant double (3) comprenant deux autres transistors (M3, M4), dont chacun est connecté à un branche différente des deux branches du circuit à paire différentielle de commande de gain (30), également à chacune des deux branches du circuit à paire différentielle de commande de gain (30), et
dans lequel un courant (I₂) est fourni par une source de courant (2) du circuit de réglage de mode commun (110; 210; 310) et le courant (I₂) est fourni, par un circuit de commande (I20 ; 220 ; 320) du circuit de réglage de mode commun (110 ; 210 ; 310), pour générer une partie du courant de polarisation (I_{bias}) en fonction d'une amplification souhaitée du VGA (10 ; 20).
